(19) Europäisches Patentamt
European Patent Office
Office européen des brevets

(11) **EP 4 414 731 A1**

(12) **EUROPÄISCHE PATENTANMELDUNG**

(43) Veröffentlichungstag:
**14.08.2024  Patentblatt 2024/33**

(51) Internationale Patentklassifikation (IPC):
**G01R 33/00** *(2006.01)*   **G01R 33/022** *(2006.01)*

(21) Anmeldenummer: **24152674.8**

(52) Gemeinsame Patentklassifikation (CPC):
**G01R 33/0017; G01R 33/0035; G01R 33/022**

(22) Anmeldetag: **18.01.2024**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH MA MD TN**

(30) Priorität: **31.01.2023  DE 102023200774**

(71) Anmelder: **Robert Bosch GmbH**
**70442 Stuttgart (DE)**

(72) Erfinder:
• ZEGOWITZ, Michael
  **72108 Rottenburg Am Neckar (DE)**
• BREITFELD, Andreas
  **70567 Stuttgart (DE)**
• RALL, Astrid
  **74211 Leingarten (DE)**
• WIENS, Andreas
  **72800 Eningen Unter Achalm (DE)**
• SCHICKLE, Sven
  **72070 Tuebingen (DE)**

(54) **VERFAHREN ZUM ANPASSEN ZUMINDEST EINER MESSGRÖSSE EINES MAGNETFELDSENSORS**

(57)      Die vorliegende Erfindung betrifft ein Verfahren (100) zum Anpassen zumindest einer Messgröße eines Magnetfeldsensors, aufweisend die Schritte Erzeugen (S1) eines ersten Signals in einen Signalleiter (14), Erfassen (S2) des ersten Signals mittels einer ersten Messung durch einen ersten Magnetfeldsensor (18) mit einer ersten Messachse (28), einen zweiten Magnetfeldsensor (20) mit einer zweiten Messachse (32) und einen dritten Magnetfeldsensor (22) mit einer dritten Messachse (36), wobei die erste Messachse (28), die zweite Messachse (32) und die dritte Messachse (36) im Wesentlichen eine gleiche Ausrichtung (38) aufweisen, Erzeugen (S3) eines zweiten Signals in den Signalleiter (14), - Erfassen (S4) des zweiten Signals mittels einer zweite Messung durch den ersten Magnetfeldsensor (18), den zweiten Magnetfeldsensor (20) und den dritten Magnetfeldsensor (22), Erfassen (S5) der zumindest einen Messgröße mittels des ersten Magnetfeldsensors (18), des zweiten Magnetfeldsensor (20) und des dritten Magnetfeldsensors (22), Anpassen (S6) der zumindest einen erfassten Messgröße basierend auf dem erfassten ersten Signal und dem erfassten zweiten Signal.

**Fig. 1**

**Beschreibung**

Stand der Technik

Die vorliegende Erfindung betrifft ein Verfahren zum Anpassen zumindest einer Messgröße eines Magnetfeldsensors, eine Sensoreinheit mit zumindest einem Magnetfeldsensor sowie ein Fahrzeug.

Derzeit besteht eine Vielzahl an unterschiedlichen Lösungen zur Vermessung von Magnetfeldern im Fahrzeug- bzw. E-Bike-Bereich. Durch die zunehmende Anzahl an zu überwachenden Kenngrößen im Fahrzeugbereich insbesondere bei elektronisch angetriebenen Fahrrädern steigt kontinuierlich der Bedarf an innovativen und robusten Messverfahren.

Die stetige Gewichtsreduzierung im Fahrradbereich zur Effizienzsteigerung sowie der zunehmende Wettbewerb sorgt für Kostendruck, so dass günstige und effizientere Komponenten für Fahrzeuge, insbesondere Fahrräder, stärker nachgefragt werden.

Offenbarung der Erfindung

Das erfindungsgemäße Verfahren zum Anpassen zumindest einer Messgröße eines Magnetfeldsensors mit den Merkmalen des Anspruchs 1 weist gegenüber dem Bekannten den Vorteil auf, dass mithilfe des Signalleiters und des gemessenen Signals eine erfasste Messgröße der Magnetfeldsensoren angepasst werden kann, so dass keine hohen Anforderungen an die Toleranzen der Magnetfeldsensorsensitivitäten gestellt werden müssen. Dabei können vorteilhaft die gemessenen Sensitivitäten der Sensoren nur relativ für den internen Abgleich betrachtet werden, wobei nach dem Abgleich die magnetischen Störfelder wieder fehlerminimiert kompensiert werden können.

Dies ist besonders vorteilhaft, da die geringeren Sensitivitäten zu deutlich geringeren Anforderungen an den Magnetfeldsensoren führen, was sich vorteilhaft auf die Kosten des Magnetfeldsensors auswirken kann.

Dies wird erfindungsgemäß dadurch erreicht, dass das Verfahren zum Anpassen zumindest einer Messgröße eines Magnetfeldsensors die Schritte aufweist:

- Erzeugen eines ersten Signals in einem Signalleiter,
- Erfassen des ersten Signals mittels einer ersten Messung durch einen ersten Magnetfeldsensor mit einer ersten Messachse, einen zweiten Magnetfeldsensor mit einer zweiten Messachse und einen dritten Magnetfeldsensor mit einer dritten Messachse, wobei die erste Messachse, die zweite Messachse und die dritte Messachse im Wesentlichen eine gleiche Ausrichtung aufweisen,
- Erzeugen eines zweiten Signals in dem Signalleiter,
- Erfassen des zweiten Signals mittels einer zweiten Messung durch den ersten Magnetfeldsensor, den zweiten Magnetfeldsensor und den dritten Magnetfeldsensor,
- Erfassen der zumindest einen Messgröße mittels des ersten Magnetfeldsensors, des zweiten Magnetfeldsensors und des dritten Magnetfeldsensors,
- Anpassen der zumindest einen erfassten Messgröße basierend auf dem erfassten ersten Signal und dem erfassten zweiten Signal.

In anderen Worten wird mittels des Signalleiters das Signal an den drei Magnetfeldsensoren vorbeigeführt, so dass die drei Magnetfeldsensoren jeweils das gleiche Signal erfassen können, um mithilfe des Signals eine Messgröße des zumindest einen Magnetfeldsensors anpassen zu können. Dabei weisen die drei Magnetfeldsensoren eine im Wesentlichen gleiche Messachse auf bzw. eine Messachse, welche die jeweils gleiche Ausrichtung aufweist. Im Wesentlichen gleiche Ausrichtung kann in diesem Zusammenhang eine Abweichung von $\pm < 5°$ bedeuten. Beispielsweise weisen sowohl der erste Magnetfeldsensor, der zweite Magnetfeldsensor und der dritte Magnetfeldsensor jeweils zumindest eine Messachse auf, welche alle die gleiche Orientierung aufweisen bzw. Ausrichtung aufweisen. Ferner kann ein erstes Signal in den Signalleiter geleitet werden, so dass der erste Magnetfeldsensor, der zweite Magnetfeldsensor und der dritte Magnetfeldsensor dieses Signal erfassen können. Ferner wird ein zweites Signal in den Signalleiter gegeben, welches wieder vom ersten Magnetfeldsensor, vom zweiten Magnetfeldsensor und/oder vom dritten Magnetfeldsensor erfasst werden kann. Die Erfassung bzw. Messung des ersten Signals und des zweiten Signals mit der Vielzahl an Magnetfeldsensoren kann dazu genutzt werden, eine Differenz zwischen der ersten und der zweiten Messung auszubilden. Mittels der Differenz kann insbesondere die erfasste Messgröße angepasst werden, welche von den Magnetfeldsensoren überwacht wird. Dabei können die Werte der ersten Messung und der zweiten Messung von einem Offset befreit sein. Das Offset der einzelnen Magnetfeldsensoren kann einmalig für eine Messanordnung bestimmt werden und für die Lebensdauer der Messanordnung verwendet werden. Bspw. kann das Offset durch eine Zweitpunktkalibrierung erfolgen, wobei der erste Punkt bei einem Drehmoment von 0 Nm erfolgen kann und der zweite Punkt bei 80 Nm Drehmoment eines elektrischen Antriebs eines Fahrrads.

Die Unteransprüche zeigen bevorzugte Weiterbildungen der Erfindung.

Bevorzugt ist das Verfahren messbetriebsunterbrechungsfreien und diagnosestromdrifttoleranten Kompensation von differentiellen Sensitivitäts-Drifts von Magnetfeldsensoren in Differential-Mode-Auswertung eingerichtet. Weiter bevorzugt ist das Verfahren zur messbetriebsunterbrechungsfreien und diagnosestromdrifttoleranten Kompensation von differentiellen Magnetfeldsensor-Sensitivitäts-Drifts eines Differential-Mode-Magnetfeldsensor-Systems.

Weiterbevorzugt ist das Verfahren dazu eingerichtet bei dem Erzeugen des ersten Signals und des zweiten Signals nur einen einzelnen Strom und/oder Stromimplus in den Signalleiter zu erzeugen und in einen Signalleiter zu leiten.

Vorzugsweise weist das Verfahren ferner die Schritte auf:

- Bilden einer ersten Differenz zwischen der ersten Messung und der zweiten Messung des ersten Magnetfeldsensors,
- Bilden einer zweiten Differenz zwischen der ersten Messung und der zweiten Messung des zweiten Magnetfeldsensors,
- Bilden einer dritten Differenz zwischen der ersten Messung und der zweiten Messung des dritten Magnetfeldsensors,
- Anpassen der zumindest einen erfassten Messgröße basierend auf der ersten Differenz, der zweiten Differenz und/oder der dritten Differenz.

Ein Vorteil dieser Ausführungsform ist, dass mithilfe der Differenzen die Messabweichung bzw. eine Funktionsweise des jeweiligen Magnetfeldsensors erfasst werden kann. Dabei kann das Erfassen einer Differenz periodisch wiederholt werden, insbesondere über eine Vielzahl von Messungen. Insbesondere kann bei einem Verlauf der Differenzen über die Zeit, dieser genutzt werden, um die zumindest eine erfasste Messgröße anzupassen.

Weiter bevorzugt weist das Verfahren die Schritte auf:

- Bilden eines ersten Verhältnisses zwischen der zweiten Differenz und der ersten Differenz,
- Bilden eines zweiten Verhältnisses zwischen der zweiten Differenz und der dritten Differenz,
- Anpassen der zumindest einen erfassten Messgröße basierend auf dem ersten Verhältnis und/oder dem zweiten Verhältnis.

Ein Vorteil dieser Ausführungsform ist, dass mithilfe der Verhältnisse ein relativer Initialabgleich erfolgen kann, welcher in Betracht für die Anpassung der zumindest einen Messgröße gezogen werden kann.

Bevorzugt umfasst das Verfahren ferner die Schritte:

- Empfang und/oder Ermitteln einer ersten Kalibrierung des ersten Magnetfeldsensors,
- Empfang und/oder Ermitteln einer zweiten Kalibrierung des zweiten Magnetfeldsensors,
- Empfang und/oder Ermitteln einer dritten Kalibrierung des dritten Magnetfeldsensors,
- Anpassen der ersten Differenz basierend auf der ersten Kalibrierung,
- Anpassen der zweiten Differenz basierend auf der zweiten Kalibrierung,
- Anpassen der dritten Differenz basierend auf der dritten Kalibrierung.

Ein Vorteil dieser Ausführungsform ist, dass mithilfe einer Kalibrierung des jeweiligen Magnetfeldsensors die Genauigkeit zur Anpassung der zumindest einen Messgröße weiter verfeinert werden kann, da beispielsweise der Magnetfeldsensor während der Fertigung kalibriert werden kann und diese Kalibrierung für die Lebensdauer des Magnetfeldsensors weiter verwendet werden kann. Somit können insbesondere fertigungsbedingte Toleranzen ausgeglichen werden.

Weiter bevorzugt weist das Verfahren die Schritte auf:

- Anpassen der zumindest einen Messgröße basierend auf einem Vergleich zwischen einer ersten Variablen und einer zweiten Variablen, wobei die erste Variable einen Subvergleich zwischen einer ersten Kombination der ersten Differenz mit dem ersten Verhältnis und dem zweiten Verhältnis ist,
- wobei die zweite Variable ein zweiter Subvergleich zwischen einer zweiten Differenz und einer zweiten Kombination der dritten Differenz mit dem zweiten Verhältnis ist.

Ein Vorteil dieser Ausführungsform ist, dass mit dem Vergleich zwischen der ersten und zweiten Variablen eine Kalibrierung der Messgröße erfolgen kann, so dass die Genauigkeit der Magnetfeldsensoren weiter erhöht werden kann. Dabei handelt es sich insbesondere bei dem Vergleich zwischen der ersten Variablen und der zweiten Variablen um eine Subtraktion zwischen der ersten und zweiten Variablen. Weiter bevorzugt wird der Vergleich zwischen der ersten und zweiten Variablen um die Sensitivität des Magnetfeldsensors erweitert.

Ferner weist das Verfahren den Schritt auf:

- Wiederholen des Anpassens der zumindest einen Messgröße mit einer vorbestimmten Frequenz, wobei das erste Verhältnis und das zweite Verhältnis bei dem Wiederholen unverändert bleiben.

Ein Vorteil dieser Ausführungsform ist, dass durch das initiale Kalibrieren des ersten und des zweiten Verhältnisses die Genauigkeit der erfassten Messgröße weiter verbessert werden kann, da durch das Wiederholen des Anpassens bei einer vorbestimmten Frequenz Veränderungen wie beispielsweise eine Temperaturerhöhung beim Anpassen der Messgröße berücksichtigt werden können.
Ferner weist das Verfahren die Schritte auf:

- Bilden eines dritten Verhältnisses zwischen der ersten Differenz und der dritten Differenz,
- Anpassen der zumindest einen Messgröße basierend auf dem ersten Verhältnis, dem zweiten Verhältnis und/oder dem dritten Verhältnis.

Ein Vorteil dieser Ausführungsform ist, dass mittels der drei Verhältnisse ein differenzieller Magnetfeldsensor-Sensitivitätsdrift kompensiert werden kann, insbesondere durch den relativen Abgleich zwischen den einzelnen Magnetfeldsensoren. Dies hat den Vorteil, dass keine hohen Anforderungen an die Genauigkeit bzw. der Stabilität der Sensitivitäten beispielsweise über Temperaturbereiche gestellt werden müssen.
Ferner weist das Verfahren die Schritte auf:

- Anpassen der zumindest einen Messgröße basierend auf einem weiteren Vergleich zwischen einer dritten Variablen und einer vierten Variablen sowie eines Gesamtverhältnisses, wobei die dritte Variable einen Vergleich einer dritten Kombination der ersten Differenz mit dem ersten Verhältnis und der zweiten Differenz ist,
- wobei die vierte Variable ein Vergleich zwischen der zweiten Differenz und einer vierten Kombination der dritten Differenz mit dem zweiten Verhältnis ist,
- wobei das Gesamtverhältnis ein Vergleich zwischen dem ersten Verhältnis, dem zweiten Verhältnis, dem dritten Verhältnis und einer Inverse des dritten Verhältnisses ist.

Ein Vorteil dieser Ausführungsform ist, dass keine hohen Anforderungen an die initialen Toleranzen der Magnetfeldsensor-Sensitivitäten gestellt werden müssen und auch nicht an die Genauigkeit der Stabilität der Sensitivitäten beispielsweise über Temperaturbereiche. Dabei ist der Vergleich zwischen der dritten und vierten Variablen bevorzugt eine Subtraktion zwischen der dritten und vierten Variablen, wobei das Ergebnis der Subtraktion durch das Gesamtverhältnis geteilt wird.
Ferner weist das Verfahren die Schritte auf:

- Wiederholen des Anpassens der zumindest einen Messgröße in einer weiteren Frequenz,
- Wiederholen des Bildens des ersten Verhältnisses, des zweiten Verhältnisses und des dritten Verhältnisses in einer zusätzlichen Frequenz, wobei die weitere Frequenz größer und/oder gleich der zusätzlichen Frequenz ist.

Ein Vorteil dieser Ausführungsform ist, dass die Veränderung der Gesamtsensivität durch den zyklischen Abgleich bzw. die Wiederholung anhand einer vorbestimmten Frequenz minimiert werden kann. Ferner kann der Erhalt der Störfeldkombinationseigenschaften verbessert werden.
Ferner umfasst das Verfahren die Schritte:

- Abgleichen der ersten Messung sowie der zweiten Messung des ersten Magnetfeldsensors, des zweiten Magnetfeldsensors und des dritten Magnetfeldsensors zu einem Sensor, welcher in einer Sensorgruppe mittig angeordnet ist.

Ein Vorteil dieser Ausführungsform ist, dass die Sensitivität des Sensors, welcher in der Mitte positioniert ist, genutzt wird, um den Abgleich zu bewerkstelligen. Somit können auch lineare Störfeldgradienten weiter kompensiert werden. Beispielsweise sind der erste Magnetfeldsensor, der zweite Magnetfeldsensor und der dritte Magnetfeldsensor in einer Art Sensorgruppe angeordnet, wobei der in der Mitte liegende Sensor wie beispielsweise der zweite Magnetfeldsensor dazu genutzt wird, die erste Messung sowie die zweite Messung abzugleichen bzw. diese für eine Kalibrierung zu nutzen.
Ferner weist das Abgleichen der ersten Messung und der zweiten Messung die Schritte auf:

- Kalibrieren der zumindest einen Messgröße mittels einem Vergleich zwischen einer ersten Kalibrierungsvariablen, einer zweiten Kalibrierungsvariablen,
- wobei die erste Kalibrierungsvariable ein Vergleich zwischen der ersten Differenz und der zweiten Differenz ist, wobei die zweite Kalibrierungsvariable ein Vergleich zwischen der zweiten Differenz und der dritten Differenz ist.

Ein Vorteil dieser Ausführungsform ist, dass mithilfe der Kalibrierung der erfassten Messgröße die Genauigkeit der zumindest einen Messgröße weiter erhöht werden kann. Dabei handelte es sich bei dem Vergleich zwischen der ersten Kalibrierungsvariablen und der zweiten Kalibrierungsvariablen insbesondere um eine Subtraktion zwischen der ersten Kalibrierungsvariablen und der zweiten Kalibrierungsvariablen. Ferner ist der Vergleich zwischen der ersten Differenz und der zweiten Differenz ebenso eine Subtraktion wie der Vergleich zweiten Differenz und der dritten Differenz.
Ferner weist das Verfahren das Schritte auf:

- Bilden eines ersten Fix-Verhältnisses, eines zweiten Fix-Verhältnisses und eines dritten Fix-Verhältnisses,

wobei das erste Fix-Verhältnis ein Vergleich zwischen der ersten Differenz und der zweiten Differenz ist, wobei das zweite Fix-Verhältnis ein Vergleich zwischen der zweiten Differenz und der dritten Differenz ist, wobei das dritte Fix-Verhältnis ein Vergleich zwischen der ersten Differenz und der dritten Differenz ist,

- Anpassen der zumindest einen Messgröße basierend auf einem Vergleich einer fünften Variablen, einer sechsten Variablen und einem zweiten Gesamtverhältnis,
- wobei die fünfte Variable ein dritter Subvergleich zwischen einer vierten Kombination der ersten Differenz mit dem ersten Verhältnis und mit dem Fix-Verhältnis und der zweiten Differenz ist,
- wobei die sechste Variable ein vierter Subvergleich zwischen der zweiten Differenz und einer fünften Kombination der dritten Differenz mit dem zweiten Verhältnis und mit dem zweiten Fix-Verhältnis ist,
- wobei das zweite Gesamtverhältnis ein fünfter Subvergleich zwischen einer sechsten Kombination einer siebten Kombination, einer achten Kombination und einer Inversen der siebten Kombination ist,
- wobei die sechste Kombination ein viertes Verhältnis zwischen dem ersten Verhältnis und der ersten Kalibrierung ist,
- wobei die siebte Kombination ein fünftes Verhältnis zwischen dem zweiten Verhältnis und der zweiten Kalibrierung ist,
- wobei die achte Kombination ein sechstes Verhältnis zwischen dem dritten Verhältnis und der dritten Kalibrierung ist.

Ein Vorteil dieser Ausführungsform ist, dass die Veränderung der Gesamtsensitivität minimiert werden kann. Ferner kann mittels des Vergleiches zwischen der fünften Variablen, der sechsten Variablen und einem zweiten Gesamtverhältnis die Störfeldkompensationseigenschaften in ihrem Erhalt verbessert werden. Dabei kann der Vergleich zwischen der fünften und der sechsten Variablen insbesondere eine Subtraktion sein, wobei das Ergebnis der Subtraktion mit dem zweiten Gesamtverhältnis multipliziert werden kann. Dabei kann die Messgröße mit der Formel angepasst werden:

$$\text{Messgröße} = ((\Delta B_{x1} * ca_x / ca_{x,calib} - \Delta B_{x2}) - (\Delta B_{x2} - \Delta B_{x3} * cb_x / cb_{x,calib})) * 4 / (ca_x / ca_{x,calib} + cb_x / cb_{x,calib} + cc_x / cc_{x,calib} + cc_{x,calib} / cc_x) / \text{Sensitivität}$$

$\Delta Bx_1$ kann dabei die erste Differenz sein. $ca_x$ kann das erste Verhältnis sein. Das erste Verhältnis kann mit $ca_x = \Delta B_{x2} / \Delta B_{x1}$ beschrieben werden. Das erste Fix-Verhältnis $ca_{x,calib}$ kann mit $ca_{x,calib} = \Delta B_{x2} / \Delta B_{x1}$ beschrieben werden, wobei das erste Fix-Verhältnis einmalig gebildet wird, insbesondere bei einer Fertigung und/oder einer Montage des Magnetfeldsensors. Die erste Differenz kann mit $\Delta Bx_1 = b_1 - a_1$ beschrieben werden. Dabei kann $b_1$ die zweite Messung mit dem ersten Magnetfeldsensor sein. Ferner kann $a_1$ die erste Messung mit dem ersten Magnetfeldsensor sein.
$\Delta Bx_2$ kann dabei die zweite Differenz sein. $cb_x$ kann das zweite Verhältnis sein. Das zweite Verhältnis kann mit $cb_x = \Delta B_{x2} / \Delta B_{x3}$ beschrieben werden. Das zweite Fix-Verhältnis $cb_{x,calib}$ kann mit $cb_{x,calib} = \Delta B_{x2} / \Delta B_{x3}$ beschrieben werden, wobei das zweite Fix-Verhältnis einmalig gebildet wird, insbesondere bei einer Fertigung und/oder einer Montage des Magnetfeldsensors. Die zweite Differenz kann mit $\Delta Bx_2 = b_2 - a_2$ beschrieben werden. Dabei kann $b_2$ die zweite Messung mit dem zweiten Magnetfeldsensor sein. Ferner kann $a_2$ die erste Messung mit dem zweiten Magnetfeldsensor sein.
$\Delta Bx_3$ kann dabei die dritte Differenz sein. $cc_x$ kann das dritte Verhältnis sein. Das dritte Verhältnis kann mit $cc_x = \Delta B_{x1} / \Delta B_{x3}$ beschrieben werden. Das dritte Fix-Verhältnis $cc_{x,calib}$ kann mit $cc_{x,calib} = \Delta B_{x1} / \Delta B_{x3}$ beschrieben werden, wobei das dritte Fix-Verhältnis einmalig gebildet wird, insbesondere bei einer Fertigung und/oder einer Montage des Magnetfeldsensors. Die dritte Differenz kann mit $\Delta Bx_3 = b_3 - a_3$ beschrieben werden. Dabei kann $b_3$ die zweite Messung mit dem dritten Magnetfeldsensor sein. Ferner kann $a_3$ die erste Messung mit dem dritten Magnetfeldsensor sein.
Ferner kann das Kalibrieren der zumindest einen Messgröße mittels der Formel erfolgen: Messgröße = $((\Delta B_{x1} - \Delta B_{x2}) - (\Delta B_{x2} - \Delta B_{x3}))$ / Sensitivität Ferner kann das zweite Signal einen logischen Wert von 5 aufweisen. Das erste Signal kann mittels der ersten Messung des ersten Magnetfeldsensors, des zweiten Magnetfeldsensors und des dritten Magnetfeldsensors erfasst werden. Das zweite Signal kann mittels der zweiten Messung des ersten Magnetfeldsensors, des zweiten Magnetfeldsensors und des dritten Magnetfeldsensors erfasst werden.

Weiter bevorzugt weist das Anpassen der zumindest einen Messgröße den Schritt auf:

- Anpassen der zumindest einen Messgröße der ersten Messung und/oder der zweiten Messung des ersten Magnetfeldsensors, des zweiten Magnetfeldsensors und/oder des dritten Magnetfeldsensors an eine Sensitivität des ersten Magnetfeldsensors, des zweiten Magnetfeldsensors und/oder des dritten Magnetfeldsensors.

Ein Vorteil dieser Ausführungsform ist, dass die Anpassung der zumindest einen Messgröße an die jeweilige Sensitivität des Magnetfeldsensors angepasst werden kann.

Ein weiterer Aspekt der Erfindung betrifft eine Sensoreinheit mit zumindest einem Magnetfeldsensor, welcher einen Signalgeber, einen Signalleiter und eine Logikeinheit aufweist. Ferner weist die Sensoreinheit einen ersten Magnetfeldsensor, einen zweiten Magnetfeldsensor und einen dritten Magnetfeldsensor auf. Zudem ist die Logikeinheit dazu eingerichtet, zumindest ein Signal mittels des Signalgebers zu erzeugen, wobei der Signalgeber dazu eingerichtet ist, das erzeugte Signal in den Signalleiter zu leiten. Ferner weist der Signalleiter eine erste Orientierung zu dem ersten Magnetfeldsensor mit einer ersten Messachse auf. Zudem weist der Signalleiter eine zweite Orientierung zu dem zweiten Magnetfeldsensor mit einer zweiten Messachse auf. Bevorzugt weist der Signalleiter eine dritte Orientierung zu dem dritten Magnetfeldsensor mit einer dritten Messachse auf. Zudem weisen die erste Messachse, die zweite Messachse und die dritte Messachse eine im Wesentlichen gleiche Ausrichtung auf. Ferner sind die erste Orientierung, die zweite Orientierung und die dritte Orientierung im Wesentlichen gleich. Darüber hinaus ist die Logikeinheit dazu eingerichtet, zumindest eine Messgröße mittels des ersten Magnetfeldsensors, den zweiten Magnetfeldsensors und/oder des dritten Magnetfeldsensors zu erfassen. Ferner ist die Logikeinheit dazu eingerichtet, das Verfahren wie voranstehend und nachfolgend beschrieben auszuführen. Bevorzugt kann der Signalleiter, insbesondere ein Stromleiter oder ähnliches sein. Ferner kann das Signal bspw. durch einen Strom und/oder Stromimpuls gebildet werden. Dabei kann die Sensoreinheit insbesondere zum messbetriebunterbrechungsfreien und diagnosestromdrifttoleranten Kompensation von differentiellen Sensitivitäts-Drifts von Magnetfeldsensoren in Differential-Mode-Auswertung verwendet werden. Weiter bevorzugt kann die Sensoreinheit zur messbetriebunterbrechungsfreien und diagnosestromdrifttoleranten Kompensation von differentiellen Magnetfeldsensor-Sensitivitäts-Drifts eines Differential-Mode-Magnetfeldsensor-Systems ausgebildet sein.

Weiter bevorzugt sind die erste Orientierung, die zweite Orientierung und/oder die dritte Orientierung in einem vorbestimmten Winkel zur ersten Messachse, zur zweiten Messachse und/oder zu dritten Messachse angeordnet.

Ein Vorteil dieser Ausführungsform ist, dass die mittels des vorbestimmten Winkels eine Erfassungsrichtung des Signals mittels der Magnetfeldsensoren gezielt eingestellt werden kann. Bevorzugterweise weisen die erste Orientierung, die zweite Orientierung und die dritte Orientierung einen Winkel von ungefähr 90° zur ersten Messachse, zur zweiten Messachse und zur dritten Messachse auf. Dabei kann ungefähr 90° eine Abweichung von $\pm < 5°$ umfassen.

Weiter bevorzugt handelt es sich bei dem ersten Magnetfeldsensor, dem zweiten Magnetfeldsensor und/oder dem dritten Magnetfeldsensor um einen multidifferentiell zu betreibenden bzw. auszuwertenden Magnetfeldsensor.

Weiter bevorzugt weist das erste Signal und das zweite Signal eine im Wesentlichen gleiche magnetische Feldstärke auf. Im Wesentlichen gleich kann in diesem Zusammenhang eine Abweichung von bis +/-25% zwischen dem ersten Signal und dem zweiten Signal bedeuten.

Ein weiterer Aspekt der Erfindung betrifft ein Fahrzeug, insbesondere ein elektrisch angetriebenes Fahrrad, welches eine Steuereinheit aufweist, welche dazu eingerichtet ist, das Verfahren wie voranstehend und nachfolgend beschrieben auszuführen, und/oder eine Sensoreinheit, wie voranstehend und nachfolgend beschrieben, aufweist.

Zeichnungen

Nachfolgend werden Ausführungsbeispiele der Erfindung unter Bezugnahme auf die begleitende Zeichnung im Detail beschrieben. In der Zeichnung ist:

Figur 1          eine Sensoreinheit gemäß einer Ausführungsform,

Figur 2 und 3    ein Flussdiagramm zur Illustration von Schritten des Verfahrens gemäß einer Ausführungsform,

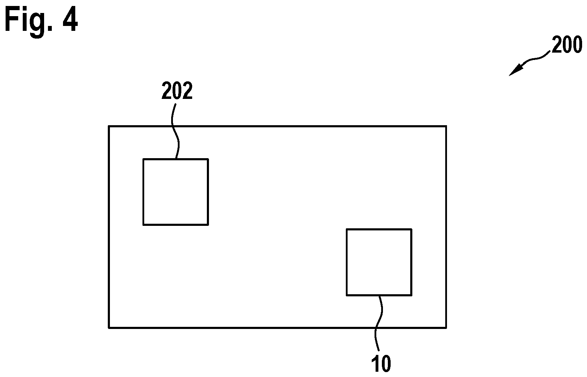

Figur 4          ein Fahrzeug einer Ausführungsform.

Ausführungsform der Erfindung

Bevorzugt sind alle gleichen Elemente, Bauteile und/oder Einheiten in allen Figuren mit den gleichen Bezugszeichen versehen.

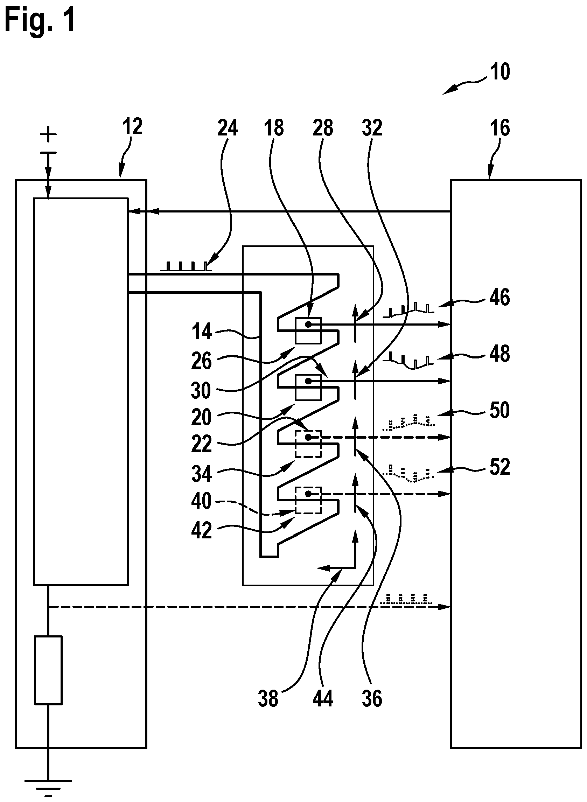

Figur 1 zeigt eine Sensoreinheit 10 gemäß einer Ausführungsform. Die Sensoreinheit 10 umfasst dabei einen Signalgeber 12, einen Signalleiter 14 sowie eine Logikeinheit 16. Ferner umfasst die Sensoreinheit 10 einen ersten Magnetfeldsensor 18, einen zweiten Magnetfeldsensor 20 sowie einen dritten Magnetfeldsensor 22. Dabei ist der Signalleiter 14 in einer ersten Orientierung 26 zu dem ersten Magnetfeldsensor 18 angeordnet. Ferner ist der Signalleiter 14 in einer zweiten Orientierung 30 zu dem zweiten Magnetfeldsensor 20 angeordnet. Darüber hinaus ist der Signalleiter in einer dritten Orientierung 34 zum dritten Magnetfeldsensor 22 angeordnet. Der erste Magnetfeldsensor 18 weist dabei eine erste Messachse 28 auf. Der zweite Magnetfeldsensor 20 weist dabei eine zweite Messachse 32 auf. Ferner weist der dritte Magnetfeldsensor 22 eine dritte Messachse 36 auf. Dabei sind die erste Messachse 28, die zweite Messachse 32 und die dritte Messachse 36 bevorzugt in einer gleichen Ausrichtung 38 angeordnet. Ferner kann die Sensoreinheit über einen vierten Magnetfeldsensor 40 verfügen. Der Signalleiter 14 ist dabei in einer vierten Orientierung 42 zum vierten Magnetfeldsensor 40 angeordnet. Der vierte Magnetfeldsensor 40 weist dabei eine vierte Messachse 44 auf, welche die gleiche Ausrichtung 38 aufweist wie die erste Messachse 28, die zweite Messachse 32 und die dritte Messachse 36. Ferner zeigt die Figur 1 einen ersten Messgrößenverlauf 46 des ersten Magnetfeldsensors 18. Ferner zeigt die Figur 1 einen zweiten Messgrößenverlauf 48 des zweiten Magnetfeldsensors 20. Darüber hinaus zeigt die Figur 1 einen dritten Messgrößenverlauf 50 des dritten Magnetfeldsensors 22. Ferner zeigt die Figur 1 einen vierten Messgrößenverlauf 52 des vierten Magnetfeldsensors 40. Dabei kann die Logikeinheit 16 ein Signal 24 mittels des Signalgebers 12 erzeugen und in den Signalleiter 14 leiten. Das Signal 24 kann mittels einer ersten Messung und einer zweiten Messung von dem ersten Magnetfeldsensor 18, dem zweiten Magnetfeldsensor 20 sowie dem dritten Magnetfeldsensor 22 erfasst werden.

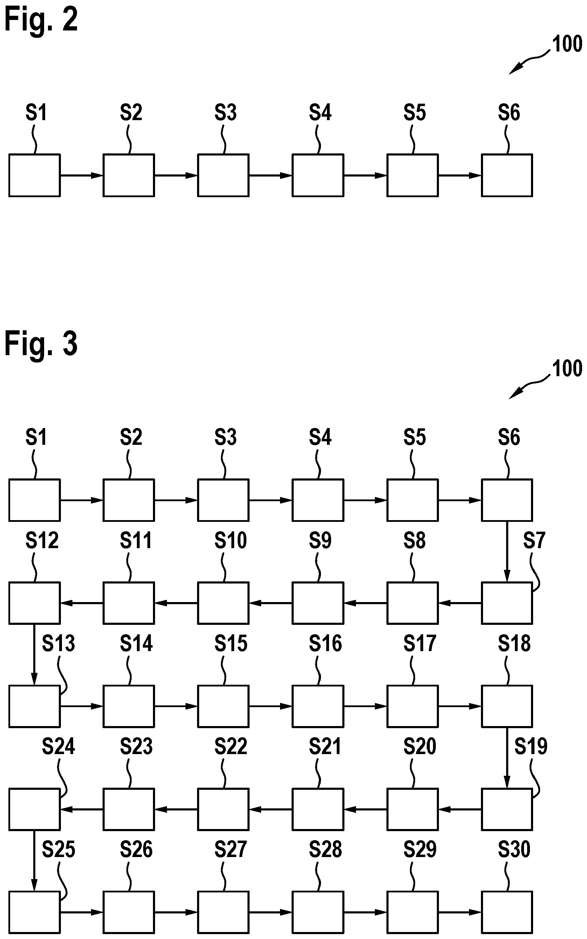

Figur 2 zeigt das Verfahren 100. Das Verfahren 100 umfasst den Schritt S1 Erzeugen eines ersten Signals mit einem ersten Wert in einem Signalleiter 14. Ferner umfasst das Verfahren 100 den Schritt S2 Erfassen des ersten Signals mittels einer ersten Messung durch einen ersten Magnetfeldsensor 18 mit einer Messachse 28, einen zweiten Magnetfeldsensor 20 mit einer zweiten Messachse 32 und einen dritten Magnetfeldsensor 22 mit einer dritten Messachse 36. Ferner weist das Verfahren 100 den Schritt S3 Erzeugen eines zweiten Signals mit einem zweiten Wert in dem Signalleiter 14 auf. Darüber hinaus weist das Verfahren 100 den Schritt S4 Erfassen des zweiten Signals mittels einer zweiten Messung durch den ersten Magnetfeldsensor 18, den zweiten Magnetfeldsensor 20 und den dritten Magnetfeldsensor 22 auf. Zudem weist das Verfahren 100 den Schritt S5 Erfassen der zumindest einen Messgröße mittels des ersten Magnetfeldsensors 18, des zweiten Magnetfeldsensors 20 und des dritten Magnetfeldsensors 22. Des Weiteren weist das Verfahren 100 den Schritt S6 Anpassen der zumindest einen erfassten Messgröße basierend auf dem erfassten ersten Signal und dem erfassten zweiten Signal auf.

Figur 3 zeigt das Verfahren gemäß einer Ausführungsform. Dabei weist das Verfahren 100 in der Figur 3 die gleichen Schritte S1 bis S6 wie in der Figur 2 beschrieben auf. Ferner weist das Verfahren 100 den Schritt S7 Bilden einer ersten Differenz zwischen der ersten Messung und der zweiten Messung des ersten Magnetfeldsensors 18 auf. Ferner weist das Verfahren 100 den Schritt S8 Bilden einer zweiten Differenz zwischen der ersten Messung und der zweiten Messung des zweiten Magnetfeldsensors 20 auf. Darüber hinaus weist das Verfahren 100 den Schritt S9 Bilden einer dritten Differenz zwischen der ersten Messung und der zweiten Messung des dritten Magnetfeldsensors 22 auf. Zudem weist das Verfahren 100 den Schritt S10 Anpassen der zumindest einen erfassten Messgröße basierend auf der ersten Differenz, der zweiten Differenz und/oder der dritten Differenz auf. Des Weiteren weist das Verfahren 100 den Schritt S11 Bilden eines ersten Verhältnisses zwischen der zweiten Differenz und der ersten Differenz auf. Darüber hinaus weist das Verfahren 100 den Schritt S12 Bilden eines zweiten Verhältnisses zwischen der zweiten Differenz und der dritten Differenz auf. Zudem weist das Verfahren 100 den Schritt S13 Anpassen der zumindest einen erfassten Messgröße basierend auf dem ersten Verhältnis und/oder dem zweiten Verhältnis. Ferner weist das Verfahren 100 den Schritt S14 Empfangen und/oder Ermitteln einer ersten Kalibrierung des ersten Magnetfeldsensors 18 auf.

Darüber hinaus weist das Verfahren 100 den Schritt S15 Ermitteln und/oder Empfangen einer zweiten Kalibrierung des zweiten Magnetfeldsensors 20 auf. Darüber hinaus weist das Verfahren 100 den Schritt S16 Ermitteln und/oder Empfangen einer dritten Kalibrierung des dritten Magnetfeldsensors 22 auf. Zudem weist das Verfahren 100 den Schritt S17 Anpassen der ersten Differenz basierend auf der ersten Kalibrierung auf. Des Weiteren umfasst das Verfahren 100 den Schritt S18 Anpassen der zweiten Differenz basierend auf der zweiten Kalibrierung. Des Weiteren umfasst das Verfahren 100 den Schritt S19 Anpassen der dritten Differenz basierend auf der dritten Kalibrierung. Des Weiteren umfasst das Verfahren 100 den Schritt S20 Anpassen der zumindest einen Messgröße basierend auf einem Vergleich zwischen einer ersten Variablen und einer zweiten Variablen.

Ferner umfasst das Verfahren 100 den Schritt S21 Wiederholen des Anpassens der zumindest einen Messgröße in einer vorbestimmten Frequenz. Zudem umfasst das Verfahren 100 den Schritt S22 Bilden eines dritten Verhältnisses zwischen der ersten Differenz und der dritten Differenz. Ferner umfasst das Verfahren 100 den Schritt S23 Anpassen der zumindest einen Messgröße basierend auf dem ersten Verhältnis, dem zweiten Verhältnis und/oder dem dritten Verhältnis. Zudem umfasst das Verfahren 100 den Schritt S24 Anpassen der zumindest einen Messgröße basierend auf einem weiteren Vergleich zwischen einer dritten Variablen und einer vierten Variablen sowie eines Gesamtverhältnisses auf. Ferner umfasst das Verfahren 100 den Schritt S25 Wiederholen des Anpassens der zumindest einen Messgröße in einer weiteren Frequenz. Ferner umfasst das Verfahren 100 den Schritt S26 Wiederholen des Bildens des ersten Verhältnisses, des zweiten Verhältnisses und des dritten Verhältnisses in einer zusätzlichen Frequenz. Ferner weist das Verfahren 100 den Schritt S27 Abgleichen der ersten Messung sowie der zweiten Messung des ersten Magnetfeldsensor 18, des zweiten Magnetfeldsensor 20 und des dritten Magnetfeldsensor 22, zu einem Sensor, welcher in einer Sensorgruppe mittig angeordnet ist, auf.

Des Weiteren weist das Verfahren 100 den Schritt S28 Kalibrieren der zumindest einen Messgröße mittels einem Vergleich zwischen einer ersten Kalibrierungsvariablen und einer zweiten Kalibrierungsvariablen auf. Darüber hinaus weist das Verfahren 100 den Schritt S29 Anpassen der zumindest einen Messgröße basierend auf einem Vergleich der fünften Variablen, einer sechsten Variablen und einem zweiten Gesamtverhältnis auf. Des Weiteren weist das Verfahren 100 den Schritt S30 Anpassen der zumindest einen Messgröße, der ersten Messung und/oder der zweiten Messung des ersten Magnetfeldsensors 18, des zweiten Magnetfeldsensors 20 und/oder des dritten Magnetfeldsensors 22 an eine Sensitivität des ersten Magnetfeldsensors 18, des zweiten Magnetfeldsensors 20 und/oder des dritten Magnetfeldsensors 22 an eine Sensitivität des ersten Magnetfeldsensors 18, des zweiten Magnetfeldsensors 20 und/oder des dritten Magnetfeldsensors 22 auf.

**Patentansprüche**

1. Verfahren (100) zum Anpassen zumindest einer Messgröße eines Magnetfeldsensors, aufweisend die Schritte:

   - Erzeugen (S1) eines ersten Signals in einen Signalleiter (14),
   - Erfassen (S2) des ersten Signals mittels einer ersten Messung durch einen ersten Magnetfeldsensor (18) mit einer ersten Messachse (28), einen zweiten Magnetfeldsensor (20) mit einer zweiten Messachse (32) und einen dritten Magnetfeldsensor (22) mit einer dritten Messachse (36), wobei die erste Messachse (28), die zweite Messachse (32) und die dritte Messachse (36) im Wesentlichen eine gleiche Ausrichtung (38) aufweisen,
   - Erzeugen (S3) eines zweiten Signals in den Signalleiter (14),
   - Erfassen (S4) des zweiten Signals mittels einer zweite Messung durch den ersten Magnetfeldsensor (18), den zweiten Magnetfeldsensor (20) und den dritten Magnetfeldsensor (22),
   - Erfassen (S5) der zumindest einen Messgröße mittels des ersten Magnetfeldsensors (18), des zweiten Magnetfeldsensor (20) und des dritten Magnetfeldsensors (22),
   - Anpassen (S6) der zumindest einen erfassten Messgröße basierend auf dem erfassten ersten Signal und dem erfassten zweiten Signal.

2. Verfahren nach Anspruch 1, wobei das Verfahren ferner die Schritte aufweist:

   - Bilden (S7) einer ersten Differenz zwischen der ersten Messung und der zweiten Messung des ersten Magnetfeldsensors (18),
   - Bilden (S8) einer zweiten Differenz zwischen der ersten Messung und der zweiten Messung des zweiten Magnetfeldsensors (20),
   - Bilden (S9) einer dritten Differenz zwischen der ersten Messung und der zweiten Messung des dritten Magnetfeldsensors (22),
   - Anpassen (S10) der zumindest einen erfassten Messgröße basierend auf der ersten Differenz, der zweiten Differenz und/oder der dritten Differenz.

3. Verfahren nach Anspruch 2, wobei das Verfahren die Schritte aufweist:

   - Bilden (S11) eines ersten Verhältnisses zwischen der zweiten Differenz und der ersten Differenz,
   - Bilden (S12) eines zweiten Verhältnisses zwischen der zweiten Differenz und der dritten Differenz,
   - Anpassen (S13) der zumindest einen erfassten Messgröße basierend auf dem ersten Verhältnis und/oder dem zweiten Verhältnis.

4. Verfahren nach einem der vorherigen Ansprüche, ferner umfassend die Schritte:

   - Empfangen und/oder Ermitteln (S14) einer ersten Kalibrierung des ersten Magnetfeldsensors (18),
   - Empfangen und/oder Ermitteln (S15) einer zweiten Kalibrierung des zweiten Magnetfeldsensors (20),
   - Empfangen und/oder Ermitteln (S16) einer dritten Kalibrierung des dritten Magnetfeldsensors (22),
   - Anpassen (S17) der ersten Differenz basierend auf der ersten Kalibrierung,
   - Anpassen (S18) der zweiten Differenz basierend auf der zweiten Kalibrierung,

- Anpassen (S19) der dritten Differenz basierend auf der dritten Kalibrierung.

5. Verfahren nach einem der vorherigen Ansprüche, ferner aufweisend die Schritte:

- Anpassen (S20) der zumindest einen Messgröße basierend auf einem Vergleich zwischen einer ersten Variablen und einer zweiten Variablen, wobei die erste Variable ein Subvergleich zwischen einer ersten Kombination der ersten Differenz mit dem ersten Verhältnis und der zweiten Verhältnis ist,
- wobei die zweite Variable ein zweiter Subvergleich zwischen der zweiten Differenz und einer zweiten Kombination der dritten Differenz mit dem zweiten Verhältnis ist.

6. Verfahren nach einem der vorherigen Ansprüche, ferner aufweisend den Schritt:

- Wiederholen (S21) des Anpassens der zumindest einen Messgröße in einer vorbestimmten Frequenz, wobei das erste Verhältnis und das zweite Verhältnis bei dem Wiederholen unverändert bleiben.

7. Verfahren nach einem der vorherigen Ansprüche, ferner aufweisend die Schritte:

- Bilden (S22) eines dritten Verhältnisses zwischen der ersten Differenz und der dritten Differenz,
- Anpassen (S23) der zumindest einen Messgröße basierend auf dem ersten Verhältnis, dem zweiten Verhältnis und/oder dem dritten Verhältnis.

8. Verfahren nach Anspruch 7, ferner aufweisend die Schritte:

- Anpassen (S24) der zumindest einen Messgröße basierend auf einem weiteren Vergleich zwischen einer dritten Variablen und einer vierten Variablen sowie eines Gesamtverhältnisses, wobei die dritte Variable ein Vergleich einer dritten Kombination der ersten Differenz mit dem ersten Verhältnis und der zweiten Differenz ist,
- wobei die vierte Variable ein Vergleich zwischen der zweiten Differenz und einer vierten Kombination der dritten Differenz mit dem zweiten Verhältnis ist,
- wobei das Gesamtverhältnis ein Vergleich zwischen dem ersten Verhältnis, dem zweiten Verhältnis, dem dritten Verhältnis und einer Inverse des dritten Verhältnisses ist.

9. Verfahren nach einem der Ansprüche 7 bis 8, ferner umfassend die Schritte;

- Wiederholen (S25) des Anpassens der zumindest einen Messgröße in einer weiteren Frequenz,
- Wiederholen (S26) des Bildens des ersten Verhältnisses, des zweiten Verhältnisses und des dritten Verhältnisses in einer zusätzlichen Frequenz, wobei die weitere Frequenz größer und/oder gleich der zusätzlichen Frequenz ist.

10. Verfahren nach einem der Ansprüche 7 bis 9, ferner umfassend die Schritte:

- Abgleichen (S27) der ersten Messung sowie der zweiten Messung des ersten Magnetfeldsensors (18), des zweiten Magnetfeldsensors (20) und des dritten Magnetfeldsensors (22), zu einem Sensor welcher in einer Sensorgruppe mittig angeordnet ist.

11. Verfahren nach Anspruch 10, wobei das Abgleichen der ersten Messung und der zweiten Messung ferner die Schritte aufweist:

- Kalibrieren (S28) der zumindest einen Messgröße mittels einem Vergleich zwischen einer ersten Kalibrierungsvariablen und einer zweiten Kalibrierungsvariablen,
- wobei die erste Kalibrierungsvariable ein Vergleich zwischen der ersten Differenz und der zweiten Differenz ist, wobei die zweite Kalibrierungsvariable ein Vergleich zwischen der zweiten Differenz und der dritten Differenz ist.

12. Verfahren nach einem der Ansprüche 7 bis 11 und Anspruch 4, ferner aufweisend die Schritte:

- Anpassen (S29) der zumindest einen Messgröße basierend auf einem Vergleich einer fünften Variablen, einer sechsten Variablen und einem zweiten Gesamtverhältnis,
wobei die fünfte Variable ein dritter Subvergleich zwischen einer vierten Kombination der ersten Differenz mit dem ersten Verhältnis und mit der ersten Kalibrierung und der zweiten Differenz ist,

wobei die sechste Variable ein vierter Subvergleich zwischen der zweiten Differenz und einer fünften Kombination der dritten Differenz mit dem zweiten Verhältnis und mit der zweiten Kalibrierung ist,

wobei das zweite Gesamtverhältnis ein fünfter Subvergleich zwischen einer sechsten Kombination, einer siebten Kombination, einer achten Kombination und einer Inversen der siebten Kombination ist,

wobei die sechste Kombination ein viertes Verhältnis zwischen dem ersten Verhältnis und der ersten Kalibrierung ist,

wobei die siebte Kombination ein fünftes Verhältnis zwischen dem zweiten Verhältnis und der zweiten Kalibrierung ist,

wobei die achte Kombination ein sechstes Verhältnis zwischen dem dritten Verhältnis und der dritten Kalibrierung ist.

13. Verfahren nach einem der vorherigen Ansprüche, wobei das Anpassen der zumindest einen Messgröße den Schritt aufweist:

- Anpassen (S30) der zumindest einen Messgröße, der ersten Messung und/oder der zweiten Messung des ersten Magnetfeldsensors (18), des zweiten Magnetfeldsensors (20) und/oder des dritten Magnetfeldsensors (22) an eine Sensitivität des ersten Magnetfeldsensors (18), des zweiten Magnetfeldsensors (20) und/oder des dritten Magnetfeldsensors (22).

14. Sensoreinheit (10) mit zumindest einem Magnetfeldsensor, aufweisend:

- einen Signalgeber (12),
- einen Signalleiter (14),
- eine Logikeinheit (16),
- einen ersten Magnetfeldsensor (18), einen zweiten Magnetfeldsensor (20) und einen dritten Magnetfeldsensor (22),
- wobei die Logikeinheit (16) dazu eingerichtet ist, zumindest ein Signal (24) mittels des Signalgebers (12) zu erzeugen,

wobei der Signalgeber (12) dazu eingerichtet ist, das erzeugte Signal (24) in den Signalleiter (14) zu leiten,

wobei der Signalleiter (14) eine erste Orientierung (26) zu dem ersten Magnetfeldsensor (18) mit einer ersten Messachse (28) aufweist,

wobei der Signalleiter (14) eine zweite Orientierung (30) zu dem zweiten Magnetfeldsensor (20) mit einer zweiten Messachse (32) aufweist,

wobei der Signalleiter (14) eine dritte Orientierung (34) zu dem dritten Magnetfeldsensor (22) mit einer dritten Messachse (36) aufweist,

wobei die erste Messachse (28), die zweite Messachse (32) und die dritte Messachse (36) im Wesentlichen eine gleiche Ausrichtung (38) aufweisen,

wobei die erste Orientierung (26), die zweite Orientierung (30) und die dritte Orientierung (34) im Wesentlichen gleich sind,

wobei die Logikeinheit (16) dazu eingerichtet ist, zumindest eine Messgröße mittels des ersten Magnetfeldsensors (18), des zweiten Magnetfeldsensors (20) und/oder des dritten Magnetfeldsensors (22) zu erfassen

15. Sensoreinheit (10) nach Anspruch 14, **dadurch gekennzeichnet, dass** die Logikeinheit (16) dazu eingerichtet ist, das Verfahren (100) nach einem der Ansprüche 1 bis 13 auszuführen.

16. Fahrzeug (200), insbesondere ein elektrisch angetriebenes Fahrrad, welches eine Steuereinheit (202) aufweist, welche dazu eingerichtet ist, das Verfahren (100) nach einem der Ansprüche 1 bis 13 auszuführen und/oder eine Sensoreinheit (10) nach Anspruch 14 aufweist.

# Fig. 1

# Fig. 2

100

S1　　S2　　S3　　S4　　S5　　S6

# Fig. 3

100

S1　S2　S3　S4　S5　S6

S12　S11　S10　S9　S8　S7

S13　S14　S15　S16　S17　S18

S24　S23　S22　S21　S20　S19

S25　S26　S27　S28　S29　S30

**Fig. 4**

200

202

10

**EP 4 414 731 A1**

Europäisches Patentamt
European Patent Office
Office européen des brevets

## EUROPÄISCHER RECHERCHENBERICHT

Nummer der Anmeldung

EP 24 15 2674

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2019/107585 A1 (HUBER LINDENBERGER SAMUEL [CH] ET AL) 11. April 2019 (2019-04-11) | 1-15 | INV. G01R33/00 G01R33/022 |
| Y | * Absätze [0014], [0044] - [0073]; Abbildungen 1-11 * | 16 | |
| X | US 2006/152217 A1 (WITHANAWASAM LAKSHMAN S [US]) 13. Juli 2006 (2006-07-13) | 1-15 | |
| Y | * Absätze [0026] - [0047]; Abbildung 1 * | 16 | |
| Y | US 2017/336481 A1 (LATHAM ALEXANDER [US] ET AL) 23. November 2017 (2017-11-23) | 16 | |
| A | * Abbildung 4 * | 1-15 | |
| A | US 2015/316638 A1 (YAMASHITA MASAYA [JP] ET AL) 5. November 2015 (2015-11-05) * Absätze [0099] - [0116]; Abbildungen 4-8 * | 1-16 | |
| Y | US 2011/018534 A1 (PEUKERT ANDREAS [DE] ET AL) 27. Januar 2011 (2011-01-27) | 16 | RECHERCHIERTE SACHGEBIETE (IPC) |
| A | * Abbildungen 1-6 * | 1-15 | G01R |

Der vorliegende Recherchenbericht wurde für alle Patentansprüche erstellt

| Recherchenort | Abschlußdatum der Recherche | Prüfer |
|---|---|---|
| München | 3. Juli 2024 | Philipp, Peter |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

14

## ANHANG ZUM EUROPÄISCHEN RECHERCHENBERICHT
## ÜBER DIE EUROPÄISCHE PATENTANMELDUNG NR.

EP 24 15 2674

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

03-07-2024

| Im Recherchenbericht angeführtes Patentdokument | Datum der Veröffentlichung | Mitglied(er) der Patentfamilie | Datum der Veröffentlichung |
|---|---|---|---|
| US 2019107585 A1 | 11-04-2019 | CN 109633505 A | 16-04-2019 |
| | | EP 3467528 A1 | 10-04-2019 |
| | | US 2019107585 A1 | 11-04-2019 |
| US 2006152217 A1 | 13-07-2006 | KEINE | |
| US 2017336481 A1 | 23-11-2017 | EP 3449217 A1 | 06-03-2019 |
| | | EP 3825658 A1 | 26-05-2021 |
| | | US 2017336481 A1 | 23-11-2017 |
| | | US 2019049530 A1 | 14-02-2019 |
| | | WO 2017204974 A1 | 30-11-2017 |
| US 2015316638 A1 | 05-11-2015 | CN 101641609 A | 03-02-2010 |
| | | CN 103257325 A | 21-08-2013 |
| | | CN 105589050 A | 18-05-2016 |
| | | EP 2131205 A1 | 09-12-2009 |
| | | JP 5027217 B2 | 19-09-2012 |
| | | JP 5616399 B2 | 29-10-2014 |
| | | JP 6033801 B2 | 30-11-2016 |
| | | JP 2012215579 A | 08-11-2012 |
| | | JP 2014098713 A | 29-05-2014 |
| | | JP WO2008123144 A1 | 15-07-2010 |
| | | KR 20090107546 A | 13-10-2009 |
| | | US 2010117638 A1 | 13-05-2010 |
| | | US 2015316638 A1 | 05-11-2015 |
| | | WO 2008123144 A1 | 16-10-2008 |
| US 2011018534 A1 | 27-01-2011 | CN 101983340 A | 02-03-2011 |
| | | DE 102008000943 A1 | 15-10-2009 |
| | | EP 2260315 A2 | 15-12-2010 |
| | | JP 5599112 B2 | 01-10-2014 |
| | | JP 2011516842 A | 26-05-2011 |
| | | KR 20110021718 A | 04-03-2011 |
| | | US 2011018534 A1 | 27-01-2011 |
| | | WO 2009121352 A2 | 08-10-2009 |

EPO FORM P0461

Für nähere Einzelheiten zu diesem Anhang : siehe Amtsblatt des Europäischen Patentamts, Nr.12/82